(19) **Europäisches Patentamt**

**European Patent Office**

**Office européen des brevets**

(11) **EP 0 989 678 B1**

(12) **EUROPEAN PATENT SPECIFICATION**

(45) Date of publication and mention
of the grant of the patent:
**14.12.2005 Bulletin 2005/50**

(51) Int Cl.⁷: **H03M 3/02**, H03M 1/00,
G01F 1/32

(21) Application number: **99118606.5**

(22) Date of filing: **21.09.1999**

(54) **Sigma-delta analog-to-digital converter**

Sigma-delta A/D Wandler

Convertisseur analogique/ numérique sigma-delta

(84) Designated Contracting States:
**DE GB NL**

(30) Priority: **22.09.1998 JP 26812998**
        **18.02.1999 JP 3961899**
        **16.03.1999 JP 6989399**

(43) Date of publication of application:
**29.03.2000 Bulletin 2000/13**

(73) Proprietor: **Yokogawa Electric Corporation
Tokyo 180-8750 (JP)**

(72) Inventor: **Wada, Masami,
Yokogawa Electric Corporation
Musashino-shi, Tokyo 180-8750 (JP)**

(74) Representative: **Henkel, Feiler & Hänzel
Möhlstrasse 37
81675 München (DE)**

(56) References cited:
**US-A- 3 896 399**        **US-A- 4 947 171**
**US-A- 5 372 046**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

BACKGROUND OF THE INVENTION

Field of the Invention

The present invention relates to a sigma-delta analog-to-digital converter for use with a two-wire vortex flowmeter that uses a sensor to detect the vortex frequency occurring according to the flow rate of fluid under measurement, converts the detected analog signal to a digital flow-rate signal, and outputs the measured flow rate to an external device in the form of a 4-20 mA current signal that is also used as the operating power source for the external device.

More specifically, the present invention relates to a sigma-delta analog-to-digital converter in which improvements are made to the means for isolating input signals in order to reduce current consumption.

Description of the Prior Art

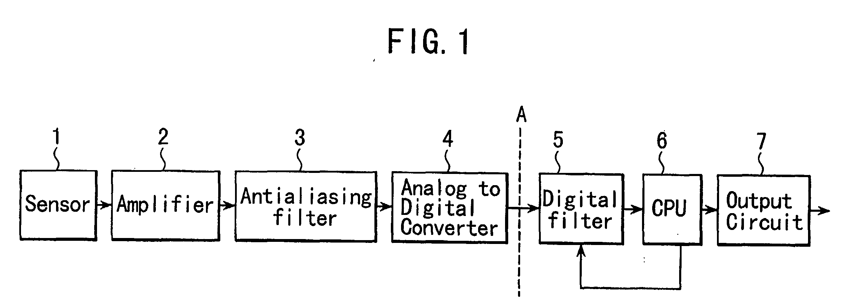

The configuration of a conventional vortex flowmeter is described by referring to FIG. 1. In the figure, an input signal from a sensor 1 for detecting vortexes produced by a vortex shedder is amplified by an amplifier 2 and inputted to an anti-aliasing filter 3. The signal inputted to the anti-aliasing filter 3 is processed thereby so that high-frequency components are removed from the signal, and then inputted to a sigma-delta analog-to-digital converter 4. The signal inputted to the sigma-delta analog-to-digital converter 4 is converted thereby into a digital signal and further inputted to a digital filter 5. The signal inputted to the digital filter 5 is thereby filtered and changed to pulses for input to a CPU 6. The CPU 6 applies processes, such as conversion to a flow-rate signal, to the inputted signal, and then outputs the flow-rate signal to an output circuit 7. The output circuit 7 outputs a 4-20 mA flow-rate signal to an external device. In the case of a two-wire vortex flowmeter, the 4-20 mA signal thus outputted also serves as an operating power source for the circuit in FIG. 1.

If a vortex flowmeter configured in such a manner as described above has a structure in which the sensor 1 is not isolated from the ground, the input signal must be isolated from the internal circuit at a certain location within the circuit in order to obtain the correct flow-rate signal.

In a regular vortex flowmeter, an isolation circuit is added to the sigma-delta analog-to-digital converter 4 so that such isolation is achieved at the section shown by the dashed line A in FIG. 1.

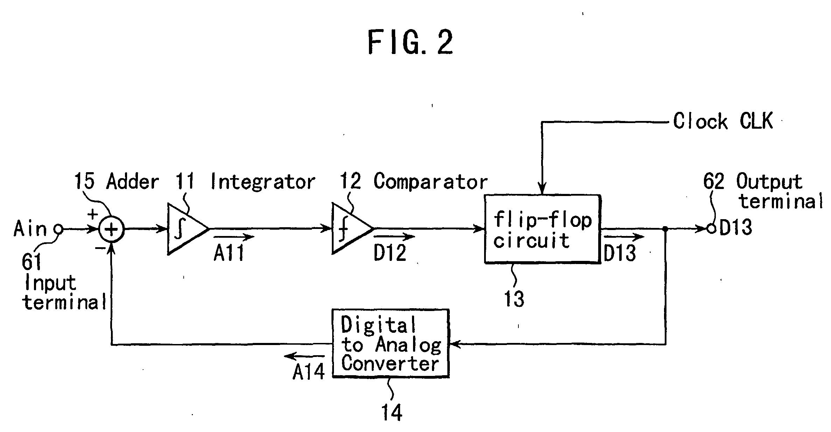

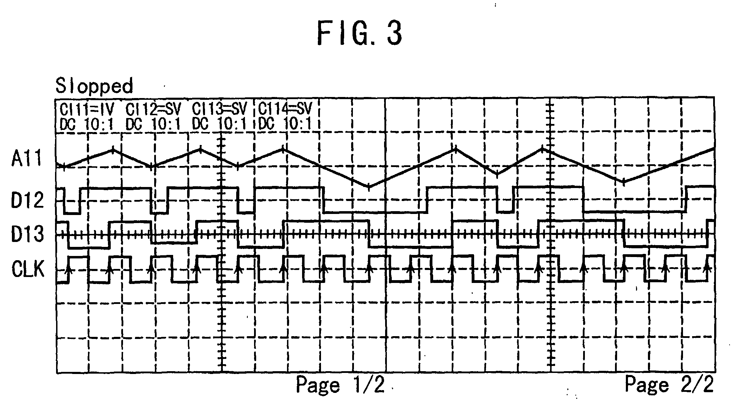

FIG. 2 is a schematic view showing the basic configuration of a conventional sigma-delta analog-to-digital converter. FIG. 3 is a timing chart showing signal waveforms at respective points in the circuit.

In FIG. 2, a signal Ain inputted from an anti-aliasing filter 3 to an input terminal 61 is fed through an adder 15 to an integrator 11, whose output is then inputted to a comparator 12.

The output of the comparator 12 is inputted to a flip-flop circuit 13, whose output is then fed to a digital filter 5 in a subsequent stage connected to the comparator through an output terminal 62. An internal clock signal CLK that serves as the sampling signal of the sigma-delta analog-to-digital converter is connected to the flip-flop circuit 13, whose output is then fed through a digital-to-analog converter 14 to the negative terminal of the adder 15.

In the sigma-delta analog-to-digital converter configured as described above, the signal Ain is integrated by the integrator 11, whose integral signal A11 is then compared with the preset value of the comparator 12. The resulting comparative output D12 is inputted to the flip-flop circuit 13, where the flip-flop circuit repeats high or low output at the timing of the clock signal CLK to produce an output D13.

The output D13 of the flip-flop circuit 13 is converted to an analog signal A14 by the digital-to-analog converter 14, and then the analog signal A14 is added to the signal Ain by the adder 15.

By repeating the operation described above, the sigma-delta analog-to-digital converter 4 can output such a pulse density signal corresponding to the signal Ain as the one labeled D13 in FIG. 3.

The sigma-delta analog-to-digital converter described above features a single-bit output (some sigma-delta analog-to-digital converters have multiple-bit output, however), small-scale hardware, ease of power saving, and a high resolution that can be attained by increasing the sampling rate and without requiring any adjustment. Accordingly, the converter has been widely used for such instruments as vortex flowmeters.

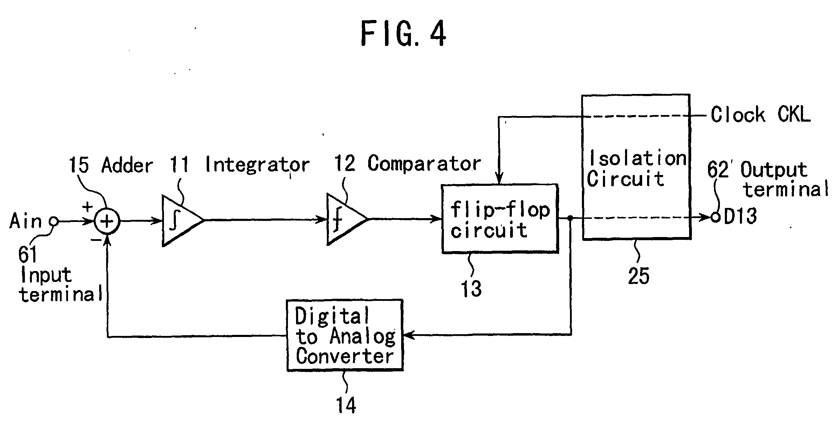

FIG. 4 shows an example of a sigma-delta analog-to-digital converter constructed as described above, where the aforementioned isolation circuit is inserted into the converter' circuit in order to isolate input signals at the location indicated by the dashed line A in FIG. 1. In FIG. 4, an isolation circuit 25 is disposed between the clock signal CLK and the output of the flip-flop circuit 13 of the sigma-delta analog-to-digital converter shown in FIG. 1, in order to isolate between the circuit including the sensor 1 on the left-hand side of the dashed line A and the circuit including the CPU 6 on the right-hand side of the dashed line A. A circuit configured in such a manner as described above is shown in the official gazette USP5372046.

However, the isolation mechanism of the conventional sigma-delta analog-to-digital converter illustrated in FIG. 4 requires that a high-frequency clock signal be properly isolated. Isolating and transferring a high-frequency signal necessitates a large amount of current, however.

Normally, sigma-delta analog-to-digital converters provide higher resolutions if an input signal is sampled at a higher frequency, since the quantization noise decreases as the sampling signal becomes faster. Generally they must sample an input signal at a frequency several hundred times as high as the signal' bandwidth.

Since vortex flowmeters use a signal bandwidth of several kilohertz, the sampling frequency must be at least several hundred kilohertz. Isolating and transferring such a high-frequency signal requires a large amount of current.

A two-wire vortex flowmeter uses a current signal of 4 to 20 mA relative to the measurement range, in order to transmit a flow-rate signal, which also serves as an operating power source, to external equipment. Consequently, the analog-to-digital converter must be operated so that its total current consumption is less than 4 mA. For this reason the sigma-delta analog-to-digital converter shown in FIG. 4 has a problem. As a result of the restriction on the amount of current consumed by the isolation circuit, the sampling frequency (or resolution) can only be increased to the extent at which isolation can be achieved at current levels no higher than 4 mA.

US 3896399 discloses a sigma-delta analog-to-digital converter according to the pre-characterizing part of claim 1. According to this state of the art a data waveform modulates a carrier to produce a data-waveform-modulated input signal v, which is applied to the input of a delta-modulation transmitter of controllable quantization-step size. The delta-modulated output signal d of the transmitter is fed through a shift register, to the individual stages of which the inputs of a coincidence gate are connected. The output signal of the coincidence gate is transmitted through a narrowband filter tuned to a frequency equal to the symbol transmission rate of the data-waveform-modulated input signal v. The narrowband-filter output signal is utilized to control quantization step size.

## SUMMARY OF THE INVENTION

It is an object of the invention to provide a sigma-delta analog-to-digital converter having a trigger control means that is designed to limit the frequency of occurence of trigger signals.

The above object is achieved by a sigma-delta analog-to-digital converter according to claim 1. The dependent claims are related to further advantageous aspects of the invention.

## BRIEF DESCRIPTION OF THE DRAWINGS

FIG. 1 is a schematic block diagram showing an example of a conventional vortex flowmeter.

FIG. 2 is a schematic block diagram showing an example of a conventional sigma-delta analog-to-digital converter

FIG. 3 is a timing chart showing signal waveforms at the respective reference points of a conventional sigma-delta analog-to-digital converter.

FIG. 4 is a schematic block diagram showing another example of a conventional sigma-delta analog-to-digital converter.

FIG. 5 is a schematic block diagram showing a first example of a sigma-delta analog-to-digital converter.

FIG. 6 is a schematic block diagram showing another example of a sigma-delta analog-to-digital converter.

FIG. 7 is a schematic block diagram showing yet another example of a sigma-delta analog-to-digital converter.

FIG. 8 is a schematic block diagram showing a first embodiment of a sigma-delta analog-to-digital converter according to the present invention.

FIG. 9 is a timing chart showing signal waveforms at the respective reference points of the trigger control circuit shown in FIG. 8.

FIG. 10 is a timing chart showing signal waveforms at the respective reference points of the sigma-delta analog-to-digital converter shown in FIG. 8.

FIG. 11 is a table showing a comparison between a conventional sigma-delta analog-to-digital converter and the sigma-delta analog-to-digital converter shown in FIG. 8.

FIG. 12 is a schematic block diagram showing another embodiment of the sigma-delta analog-to-digital converter shown in FIG. 8.

FIG. 13 is a table showing a comparison between a conventional sigma-delta analog-to-digital converter and the sigma-delta analog-to-digital converter shown in FIG. 12.

FIG. 14 is a schematic block diagram showing one embodiment of the trigger control circuit of the sigma-delta analog-to-digital converter shown in FIG. 8.

FIG. 15 is a timing chart showing signal waveforms at the respective reference points of the trigger control circuit shown in FIG. 14.

FIG. 16 is a schematic block diagram showing another example of a sigma-delta analog-to-digital converter.

FIG. 17 is a basic block diagram of the sigma-delta analog-to-digital converter shown in FIG. 16.

FIG. 18 is a schematic block diagram showing an example of the first isolation circuit of the sigma-delta analog-to-digital converter shown in FIG. 16.

FIG. 19 is a timing chart explaining the behavior of the first isolation circuit of the sigma-delta analog-to-digital converter shown in FIG. 16.

FIG. 20 is a schematic block diagram showing another example of the first isolation circuit of the sigma-delta analog-to-digital converter shown in FIG. 16.

FIG. 21 explains the behavior of the first driving circuit of the sigma-delta analog-to-digital converter shown in FIG. 16.

FIG. 22 is a timing chart explaining the behavior of the sigma-delta analog-to-digital converter shown in FIG. 16.

FIG. 23 is another timing chart explaining the behavior of the sigma-delta analog-to-digital converter shown in FIG. 16.

FIG. 24 is yet another timing chart explaining the behavior of the sigma-delta analog-to-digital converter shown in FIG. 16.

FIG. 25 is a schematic block diagram showing one embodiment of the first driving circuit of the sigma-delta analog-to-digital converter shown in FIG. 16.

FIG. 26 is a schematic block diagram showing another embodiment of the sigma-delta analog-to-digital converter shown in FIG. 16.

FIG. 27 is a schematic block diagram showing yet another embodiment of the sigma-delta analog-to-digital converter shown in FIG. 16.

## DESCRIPTION OF THE PREFERRED EMBODIMENTS

The present invention is described in detail below using the accompanying drawing.

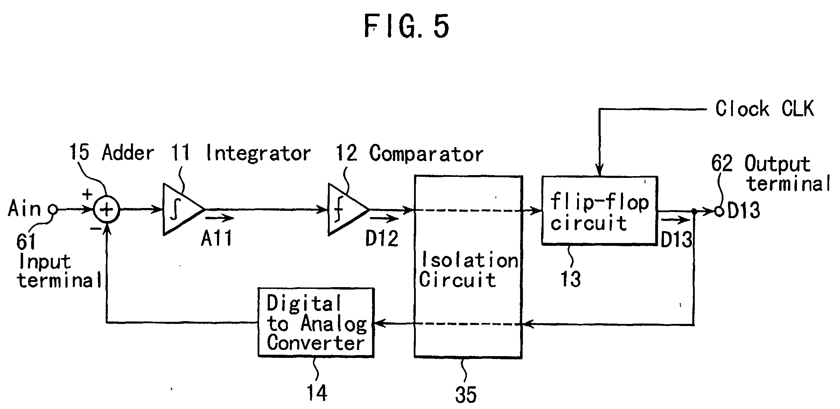

FIG. 5 is a schematic block diagram showing a sigma-delta A/D converter. In the figure, components that behave in the same way as those in FIG. 4 that explains problems with an example of a conventional sigma-delta A/D converter are given the same references and excluded from the explanation.

FIG. 5 differs from FIG. 4 in that an isolation circuit 35 is placed between a comparator 12 and a flip-flop circuit 13 and between the output terminal of the flip-flop 13 and a digital-to-analog converter 14.

The output D12 of the comparator 12 can be readily isolated from the output D13 of the flip-flop circuit 13 since both outputs deal with binary high or low signals. Unlike the circuit of FIG. 4, a high-frequency clock signal CLK does not pass through the isolation circuit in the circuit of FIG. 5.

In addition, the output signal D13 of the flip-flop circuit 13 in principle has a frequency lower than half the frequency of the clock signal CLK.

As described earlier, an isolation circuit generally consumes more current as the frequency of a signal being isolated becomes higher. Conversely, the current consumption decreases as the frequency of the signal being isolated lowers.

Since a signal to be isolated by the isolation circuit 35 is a low-frequency binary signal, no large current is necessary for the isolation circuit to isolate the signal. Consequently, the isolation circuit 35 can be easily realized using a low cost circuit of low current consumption. In addition, the frequency of the clock signal CLK that governs the resolution of the sigma-delta analog-to-digital converter can be readily increased without being subject to the above-mentioned restriction, since the clock signal CLK does not pass through the isolation circuit 35.

In the explanation given above, only a specific preferred embodiment is mentioned for the purpose of describing the present invention and showing an example of carrying out the invention. The above-mentioned embodiment is therefore to be considered as illustrative and not restrictive.

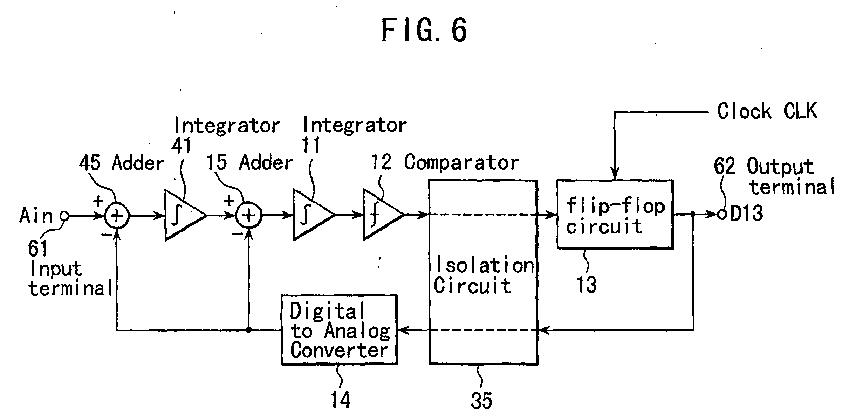

For example, the isolation means described in FIG. 5 is also effective for the double-integrator sigma-delta analog-to-digital converter shown in FIG. 6 where an adder 45 and an integrator 41 are added. It is possible to reduce the quantization noise of a sigma-delta analog-to-digital converter and improve its resolution, compared with the single-integrator type, by increasing the number of integrators as shown in FIG. 6.

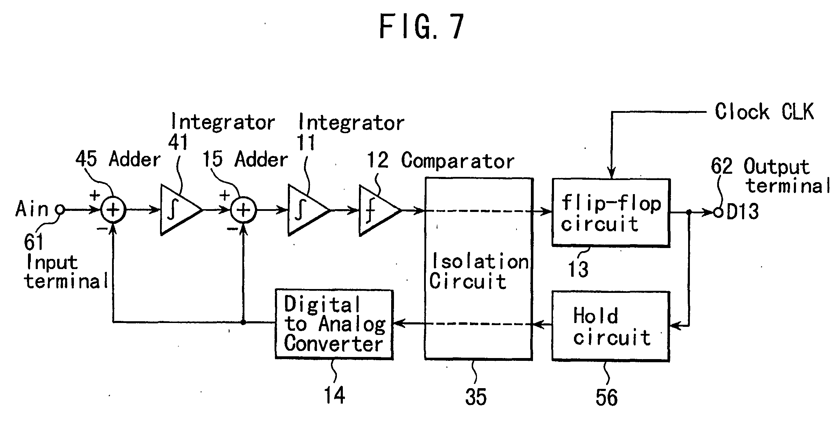

The isolation means described in FIG. 5 is also effective for a sigma-delta analog-to-digital converter where a hold circuit 56 is placed between the output terminal of the flip-flop circuit 13 and the digital-to-analog converter 14, as shown in FIG. 7. By adding the hold circuit 56 as shown in FIG. 7, the operating speed of an integrator 11 or comparator 12 can be kept low. This makes it possible to produce a sigma-delta analog-to-digital converter that requires less cost and operates at reduced currents.

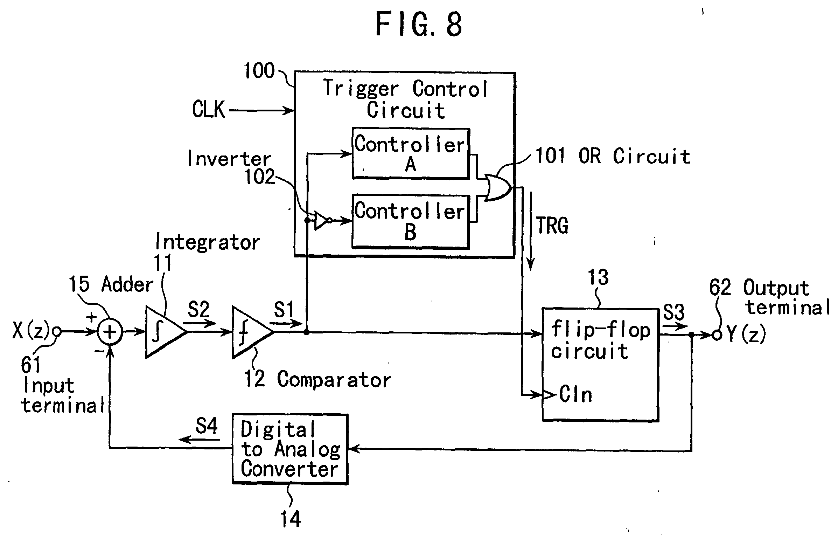

Next, a first embodiment of the present invention is described below using FIG. 8. In the figure, components that behave in the same way as those in FIG. 2 discussed earlier are given the same references and excluded from the explanation.

FIG. 8 differs from FIG. 2 in that the output of a comparator 12 is input to a trigger control circuit 100 and the output of the trigger control circuit 100 is connected to the clock input terminal Cin of the flip-flop circuit 13.

The trigger control circuit 100 is designed to limit the frequency of the occurrence of trigger signals outputted to the flip-flop circuit 13. It is provided with a controller A that detects an upward-going edge of the output of the comparator 12 to generate a trigger-component signal a and with a controller B that detects a downward-going edge of the output of the comparator 12 to generate a trigger-component signal **b**. These controllers are driven by the times of the clock signal CLK that serves as the sampling signal of the sigma-delta analog-to-digital converter. The trigger-component signals **a** and **b** generated by these controllers are input to an OR circuit 101, the output of which is then fed to the clock input terminal Cin of the flip-flop circuit 13 as a trigger signal TRG. The controllers A and B share the same circuit configuration, wherein 1) the output of the comparator 12 is directly input to the controller A within the trigger control circuit 100 so that an upward-going edge is detected to generate a trigger-component signal a and 2) the inverted output of the comparator 12 provided by an inverter 102 incorporated in the trigger control circuit 100 is input to the controller B so that a downward-going edge is detected to generate a trigger-component signal **b**.

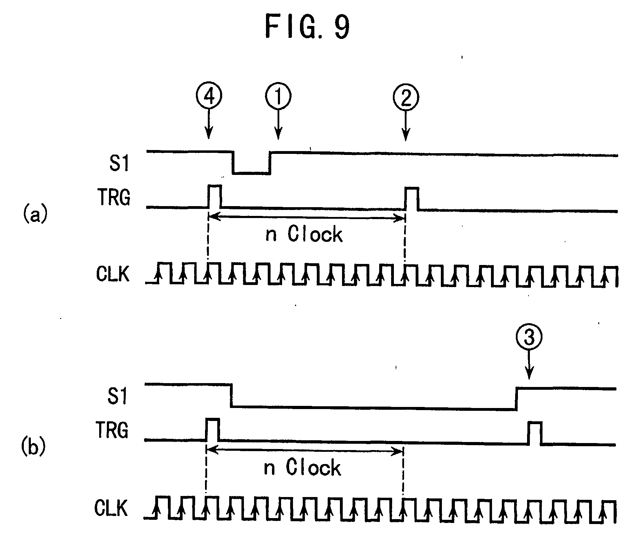

At this point, waveform charts showing the behavior of the trigger control circuit 100 discussed above are shown in FIG. 9. Each of the waveform charts (a) and (b) in the figure shows the relationship among the clock signal CLK, the output S1 of the comparator 12, and the trigger signal TRG that is the output of the trigger control circuit 100.

As explained earlier, the trigger control circuit 100 is designed to limit the frequency of the occurrence of trigger signals. The frequency is limited by controlling the time interval between the previous signal TRG and the next signal TRG.

More specifically, if the output S1 of the comparator 12 makes a low-to-high transition before the predetermined delay of $n$ clock pulses from the occurrence of the previous trigger signal TRG, then the trigger control circuit 100 generates another trigger signal TRG after a delay of n clock pulses from the occurrence of the previous trigger signal TRG. In FIG. 9 (a), the output of the comparator 12 is latched by the flip-flop circuit 13 at the time marked ① in the case of a conventional sigma-delta analog-to-digital converter. In the case of the sigma-delta analog-to-digital converter embodying the present invention, the output of the comparator 12 is latched at the time marked ② after the predetermined delay of $n$ clock pulses from the time marked ④ at which the previous trigger signal TRG occurred.

In addition, as shown in FIG. 9 (b), the trigger control circuit 100 generates a trigger signal TRG at the time marked ③ when an upward-going edge of the clock signal CLK is detected immediately after the low-to-high transition of the output S1 of the comparator 12 if that transition takes place after the predetermined delay of $n$ clock pulses from the occurrence of the previous trigger signal TRG. This behavior is the same as that of a conventional sigma-delta analog-to-digital converter.

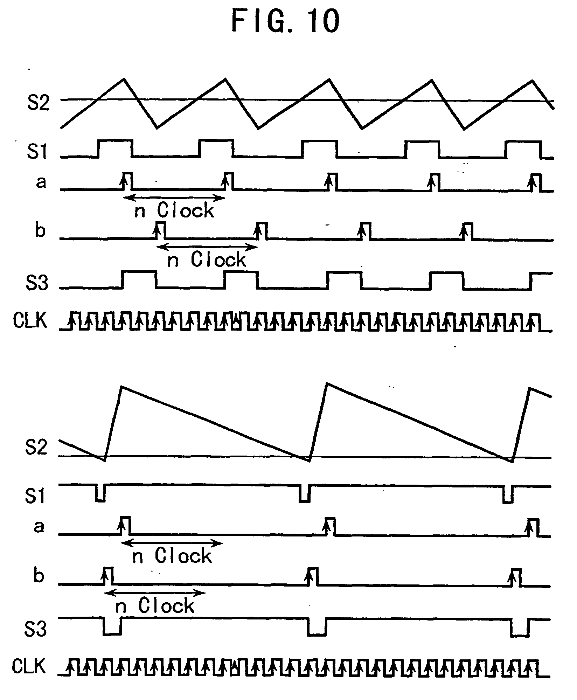

Reference is made to the waveform charts in FIG. 10 to explain the behavior of a sigma-delta analog-to-digital converter of the present invention which is provided with the trigger control circuit 100 described above. FIG. 10 (a) shows the relationship among the input S2 of the comparator 12, the output S1 of the comparator 12, the trigger-component of signal **a**, the trigger-component of signal **b**, the output S3 of the flip-flop circuit 13, and the clock signal CLK when a signal whose level is close to half the input range is applied to the sigma-delta analog-to-digital converter of the present invention. Similarly, FIG. 10 (b) shows the relationship among the same signal components as mentioned above when a signal whose level is close to the full scale of the input range is applied.

In FIG. 10 (a), the output S3 of the flip-flop circuit 13 does not change immediately even if the output S1 of the comparator 12 changes, as the trigger signal TRG, which is a logical OR of the trigger-component signals **a** and **b**, is placed under restriction. More specifically, the frequency of change in the pulse density signal input to the digital-to-analog converter 14 is reduced since the trigger signal TRG of the flip-flop circuit 13 is placed under restriction by the trigger control circuit 100. Consequently, the output of the digital-to-analog converter 14 is kept constant for a specific length of time, whereby reducing the operating speed of the analog circuit that follows the adder 15.

The output of a flip-flop circuit in a conventional sigma-delta analog-to-digital converter changes most frequently when a signal whose level is half the input range is applied. The frequency of change (hereinafter referred to as the maximum output frequency) is half the frequency of the clock signal CLK. In the case of the sigma-delta analog-to-digital converter of the present invention, the frequency is one-$n$th the frequency of the clock signal CLK. This holds true however, only if $n$ is equal to or greater than 3. The analog-to-digital converter operates in the same way as a conventional sigma-delta analog-to-digital converter if $n$ equals 1 or 2.

FIG. 10 (b) shows a waveform chart when a signal whose level is close to the full scale of the input range is applied to the sigma-delta analog-to-digital converter of the present invention. As is obvious from the figure, the output S3 of the flip-flop circuit 13 changes less frequently. This is because 1) no restriction is placed on the trigger signal TRG by the trigger control circuit 100, as the predetermined delay of n clock pulses has already occurred by the time the output S1 of the comparator 12 changes, and because 2) the trigger control circuit 100 generates a trigger signal TRG at the time when a upward-going edge of the clock signal CLK is detected immediately after a change in the output S1 of the comparator 12. This behavior is the same as that of a conventional sigma-delta analog-to-digital converter.

In other words, when the delay of n clock pulses is set properly, the trigger control circuit 100 places the trigger signal TRG under restriction only if an input signal X (z), whose level is about half the input range at which a pulse density signal Y (z) is most frequently outputted, is applied.

On the other hand, the trigger control circuit 100 does not place the trigger signal TRG under restriction if an input signal X (z), whose level is close to zero or the full scale of the input range at which a pulse density signal Y (z) changes less frequently, is applied.

An error found at the input of the comparator in the sigma-delta analog-to-digital converter configured as described above is $n/2$ times that of a conventional sigma-delta analog-to-digital converter. Therefore, the electrical energy of quantization noise is $n^2/4$ times as large and the signal-to-noise ratio SN is $4/n^2$ times as large.

Consequently, the signal-to-noise ratio SN11 when the sigma-delta analog-to-digital converter of the present invention is in a single-integrator configuration is

$$SN11 = 4/n^2 \times 9/(16 \times \pi^2) \times (fc/fs)^{-3} \tag{1}$$

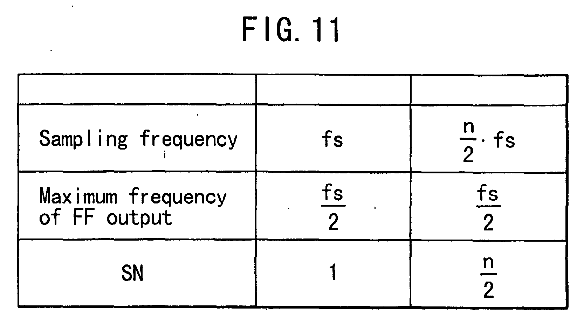

On the other hand, the frequency at which the output of the sigma-delta analog-to-digital converter changes is reduced to a value $2/n$ times the original. Consequently, if attention is paid to the operating speed of the analog circuit, including the comparator 12, and the speed is kept equal to that of the conventional method, it is understood that the clock frequency (sampling frequency) can be increased to a value $n/2$ times that of the original. FIG. 11 is the result of normalizing the signal-to-noise ratios of the conventional method and the method of the present invention by the highest frequency fS/2 of the output of the conventional sigma-delta analog-to-digital converter and then comparing them. The figure means that in the method of the present invention, it is possible to improve the advantage over the conventional method of the signal-to-noise ratio SN by a factor of $n/2$, without having to increase the operating speed of the analog circuit.

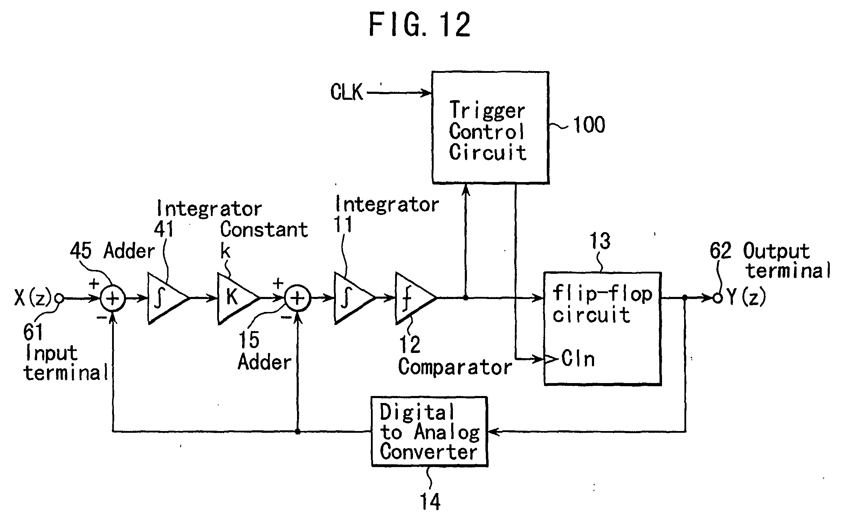

The sigma-delta analog-to-digital converter of the present invention described above may be adapted to a double-integrator sigma-delta analog-to-digital converter. In that case however, the output of the primary integrator 41 must be multiplied by a certain constant $k$ in order to stabilize the operation of the double-integrator sigma-delta analog-to-digital converter, as shown in FIG. 12. The operation can be stabilized by multiplying the output by the following constant $k$.

$$k \le 2/n \tag{2}$$

The signal-to-noise ratio SN12 in this case is

$$SN12 = k^2 \times (4/n^2) \times 15/(64 \times \pi^4) \times (fc/fs)^{-5} \tag{3}$$

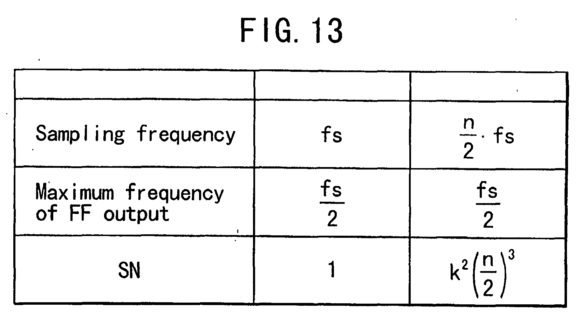

Like FIG. 11, FIG. 13 is the result of normalizing the signal-to-noise ratios of the conventional method and the method of the present invention by the highest frequency of the output of the conventional sigma-delta analog-to-digital converter and then comparing them. The figure means that in the method used with the present invention, it is possible to improve the advantage over the conventional method of the signal-to-noise ratio SN by a factor of $k^2 \times (n/2)^3$.

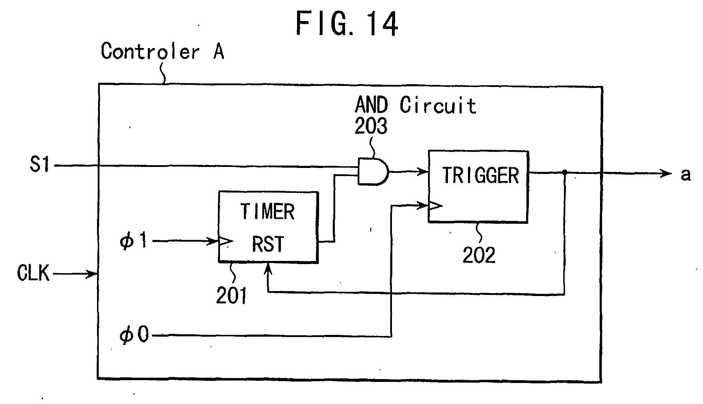

Next, an example of the controller A is explained using the schematic block diagram shown in FIG. 14.

In the figure, the output S1 of the comparator is connected to one of the inputs of an AND circuit 203 and the output of the AND circuit 203 is connected to the input of a trigger circuit 202. A clock signal φ0 is input to the trigger circuit 202.

The output of the trigger circuit 202 is connected to one of the inputs of the OR circuit contained in the trigger control circuit 100, as the trigger-component signal **a**, as well as to the reset terminal RST of the timer circuit 201. A clock signal φ1 opposite in phase to the clock signal φ0 is input to the timer circuit 201. The expiry signal S5 of the timer circuit 201 is connected to the other input of the AND circuit 203. It should be noted that the clock signals φ0 and φ1 are the result of processing the clock signal CLK input to the controller A so it is separated into two different signals.

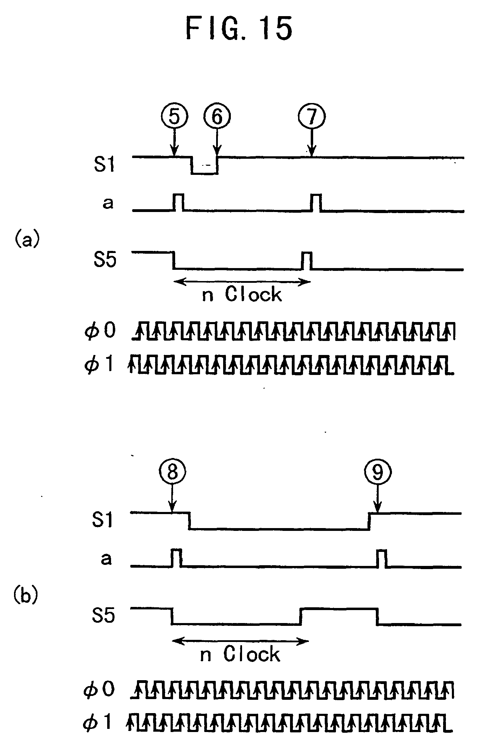

FIG. 15 shows signal waveforms at respective points of the controller A configured as described above. FIG. 15 (a) shows the operating waveforms of the controller A when the output of the comparator 12 makes a low-to-high transition before the predetermined delay of **n** clock pulses from the occurrence of the previous trigger signal TRG, as explained earlier in FIG. 9 (a). FIG. 15 (b) shows the operating waveforms of the controller A when the output of the comparator 12 makes a low-to-high transition after the predetermined delay of **n** clock pulses from the occurrence of the previous trigger signal TRG, as explained earlier in FIG. 9 (b).

In FIG. 15 (a), the controller A outputs the trigger-component signal **a** through the trigger circuit 202 and thereby resets the timer circuit 201, beginning the count of the predetermined delay of **n** clock pulses. This takes place at the time indicated by the mark ⑤ in FIG. 15 (a).

In the meantime, if the output of the comparator 12 makes a low-to-high transition before the timer circuit 201 expires, the input of the trigger circuit 202 remains low since the expiry signal S5 of the timer circuit 201 connected to the AND circuit 203 still remains low. This takes place at the time indicated by the mark ⑥ in FIG. 15 (a).

In the meantime, if the output of the comparator 12 is high when the timer circuit 201 expires and therefore its expiry signal S5 becomes high, the output of the AND circuit 203 also becomes high, thus causing the input of the trigger circuit 202 to become high and the trigger circuit 202 to output the trigger-component signal **a**. This takes place at the time indicated by the mark ⑦ in FIG. 15 (a).

Next, the behavior of the waveform chart in FIG. 15 (b) will be explained. In the figure, the controller A outputs the trigger-component signal **a** through the trigger circuit 202 and thereby resets the timer circuit 201, beginning the count of the predetermined delay of **n** clock pulses. This takes place at the time indicated by the mark ⑧ in FIG. 15 (b).

In the meantime, if the output S1 of the comparator 12 is not high when the timer circuit 201 expires and therefore its expiry signal S5 becomes high, the output S1 is held as it is.

The trigger-component signal **a** is output when the output S1 becomes high the next time. This takes place at the time indicated by the mark ⑨ in FIG. 15 (b).

By behaving in this manner, the controller A detects the upward-going edge of the output S1 of the comparator 12 to generate the trigger-component signal **a**. On the other hand, the controller B detects the downward-going edge of the output S1 of the comparator 12 to generate the trigger-component signal **b**. This is achieved by feeding the output S1 of the comparator 12, through an inverter, to the input of the controller B having the same circuit configuration as the controller A discussed here.

Furthermore, an isolation circuit shown as FIG. 5 can be placed between a comparator 12 and a flip-flop circuit 13 and between the output terminal of the flip-flop 13 and a digital-to-analog converter 14

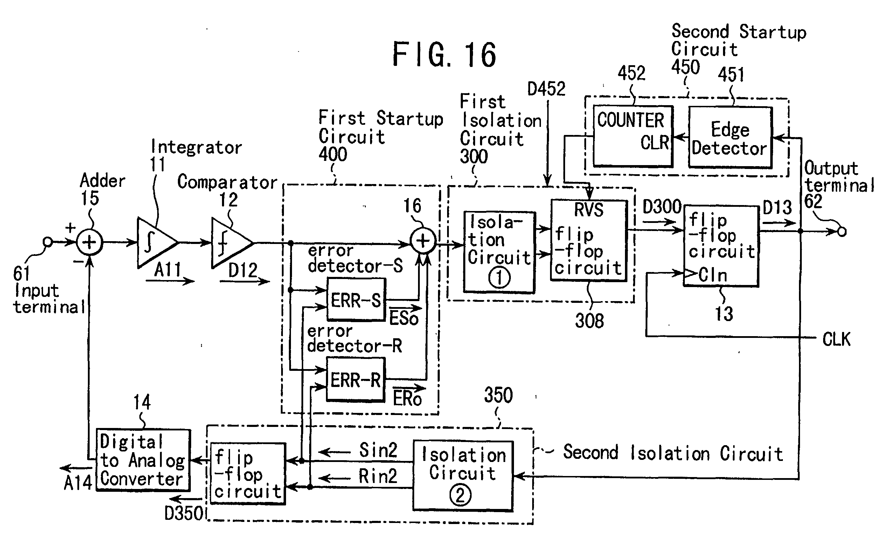

Next, a further example is explained using FIG. 16. In the figure, components that behave in the same way as those in FIG. 2 discussed earlier are given the same references and excluded from the explanation.

FIG. 16 differs from FIG. 2 in that 1) a first isolation circuit 300 is inserted between the comparator 12 and the flip-flop circuit 13, 2) a second isolation circuit 350 is inserted between the output terminal of the flip-flop circuit 13 and the digital-to-analog converter 14, and 3) the sigma-delta analog-to-digital converter is provided with first and second startup circuits that generate signals for restarting the analog-to-digital converter in case it comes to an abnormal stop when power is turned on, due to an ingress of noise, or for other reasons.

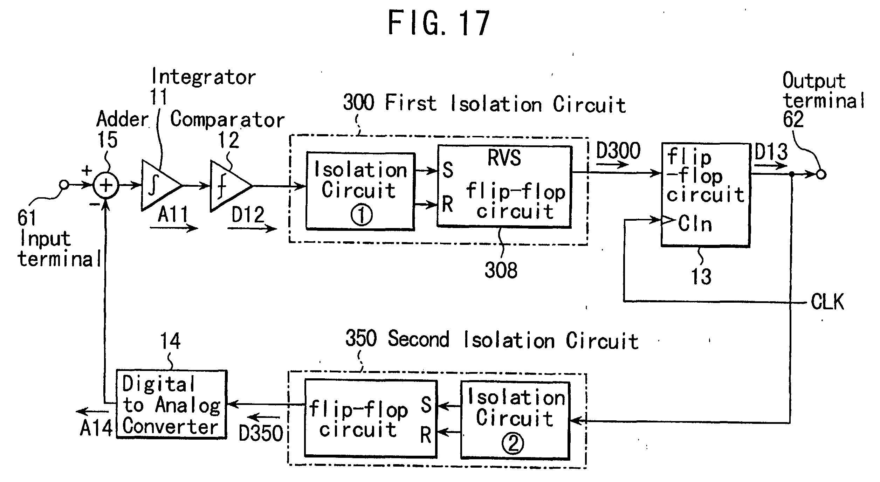

For easier understanding, we will first explain the fundamental behavior of the sigma-delta analog-to-digital converter of the present invention, using the basic block diagram of FIG. 17 where the first and second startup circuits 400 and 450 are left out.

The first isolation circuit 300 transfers, in an electrically isolated manner, only the rising-edge signal (hereinafter referred to as the upward-going-edge signal) and falling-edge signal (hereinafter referred to as the downward-going-edge signal) occur when the output signal D12 of the comparator 12 changes. It demodulates the output signal D12 of the comparator 12 according to these isolated, transferred signals.

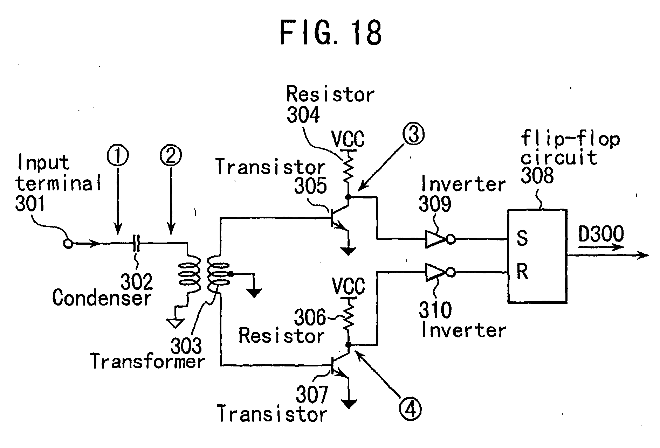

FIG. 18 shows the block diagram of the first isolation circuit 300. In the figure, an input terminal 301 is connected to one end of a differentiating capacitor 302, the other end of which is connected to one end of the primary winding of an isolation transformer 303. The other end of the primary winding of the isolation transformer 303 is connected to a primary common-potential line.

One end of the secondary winding of the isolation transformer 303 is connected to the base of a transistor 305 for detecting upward-going edges, where a power supply Vcc is fed through a resistor 304 to the collector of the transistor 305 and the emitter is connected to a secondary common-potential line.

The other end of the secondary winding of the isolation transformer 303 is connected to the base of a transistor 307 for detecting downward-going edges, where the power supply Vcc is fed through a resistor 306 to the corrector of the transistor 307 and the emitter is connected to a secondary common-potential line.

The center tap of the isolation transformer is connected to the secondary common-potential line.

The collector of the transistor 305 for detecting upward-going edges is connected through an inverter 309 to the set terminal S of the SR flip-flop circuit 308 with an inverting input.

The collector of the transistor 307 for detecting downward-going edges is connected through an inverter 310 to the reset terminal R of the SR flip-flop circuit 308 with an inverting input. The output D300 of the SR flip-flop circuit 308 is connected to the input of the flip-flop circuit 13 as the output of the first isolation circuit 300.

The SR flip-flop circuit 308 latches the output D300 to the high state if a pulse signal is input to the set terminal S, or to the low state if a pulse signal is input to the reset terminal R.

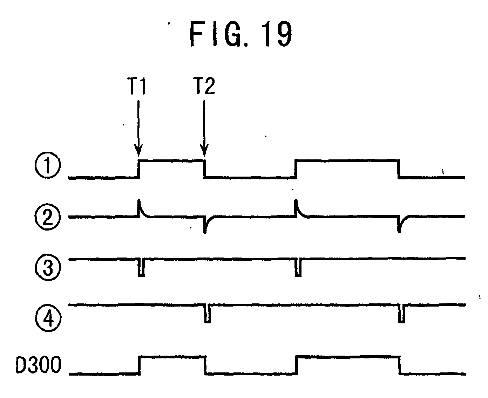

FIG. 19 shows waveforms at respective points of the first isolation circuit 300 configured as described above. The figure is a timing chart showing the relationship among an input signal ① input from the comparator 12 to the first isolation circuit 300, a differential signal ② obtained by inputting the input signal ① to the differentiating capacitor 302, the collector voltage ③ of the transistor 305 for detecting upward-going edges, the collector voltage ④ of the transistor 307 for detecting downward-going edges, and the output D300 of the SR flip-flop circuit 308 having an inverting input.

At a time T1 in FIG. 19 where the input signal ① changes from the low to high state, such an upward-going-edge signal as one shown in the differential signal ② is input to the primary winding of the isolation transformer by the effect of the differentiating capacitor 302.

The isolation transformer 303 transfers an upward-going-edge signal input to its primary winding down to its secondary winding in an electrically isolated manner, feeding current induced at the secondary winding to the base of the transistor 305. This causes the collector voltage ③ to develop at the collector of the transistor 305.

The collector voltage ③ thus produced is inverted by the inverter 309 and input to the set terminal S of the SR flip-flop circuit 308 as its set signal.

The SR flip-flop circuit 308 latches the output signal D300 to the high state using the set signal input to the set terminal S.

At the time T2 in FIG. 19 where the input signal ① changes from the high to low state, such a downward-going-edge signal as one shown in the differential signal ② is input to the primary winding of the isolation transformer by the effect of the differentiating capacitor 302.

The isolation transformer 303 transfers a downward-going-edge signal, which is input via the primary winding, to the secondary winding in an electrically isolated manner, feeding current induced at the secondary winding to the base of the transistor 307. This causes the collector voltage ④ to develop at the collector of the transistor 307.

The collector voltage ④ thus produced is inverted by the inverter 310 and input to the reset terminal R of the SR flip-flop circuit 308 as its reset signal.

The SR flip-flop circuit 308 latches the output signal D300 to the low state using the reset signal input to the reset terminal R.

By repeating the operation described above, the first isolation circuit 300 can demodulate the input signal ① input to the input terminal 301, as the output signal D300 having the same waveform as the input signal ①.

Since the first isolation circuit 300 described above transfers only the differential signal component of the input signal ① in an electrically isolated manner, it is possible to use a smaller isolation transformer, compared with methods that transfer the input signal ① as it is in an electrically isolated manner. Consequently, it is possible to downsize the isolation circuit, as well as to fabricate the circuit at lower costs.

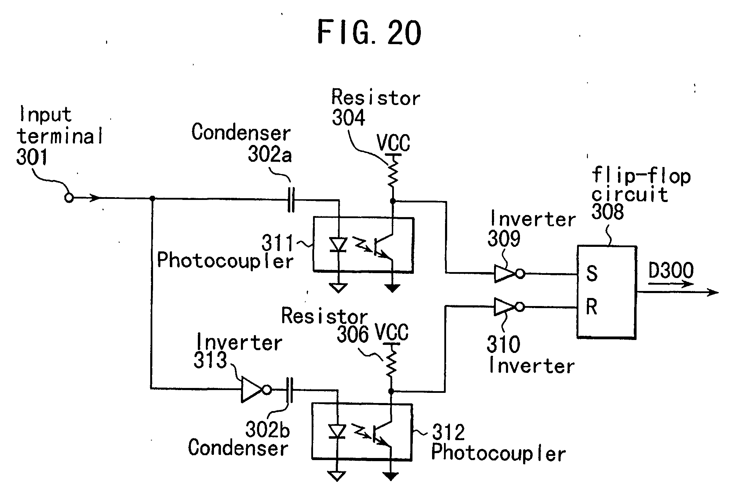

In addition, although the first isolation circuit 300 described above uses an isolation transformer, it is possible to use photocouplers as the isolation means. FIG. 20 shows an example of an isolation circuit that uses photocouplers as the isolation means. In the figure, components that behave in the same way as those of the first isolation circuit described in FIG. 18 are given the same references and excluded from the explanation.

In FIG. 20, an input terminal 301 is connected to one end of a differentiating capacitor 302a, the other end of which is connected to the light-emitting device of a photocoupler 311 for detecting upward-going edges. Likewise, the input terminal 301 is connected through an inverter 313 to one end of a differentiating capacitor 302b, the other end of which is connected to the light-emitting device of a photocoupler 312 for detecting downward-going edges.

A power supply Vcc is connected through a resistor 304 to the photoelectric detector of the photocoupler 311. The connection point between the resistor 304 and the photocoupler 311 is connected through the inverter 309 to the set terminal S of the SR flip-flop circuit 308.

A power supply Vcc is connected through a resistor 306 to the photoelectric detector of the photocoupler 312. The connection point between the resistor 306 and the photocoupler 312 is connected through the inverter 310 to the reset terminal R of the SR flip-flop circuit 308.

In the isolation circuit configured as described above, if the same signal as the input signal ① shown in FIG. 18 is input to the input terminal 301, upward-going edges are transferred by the photocoupler 311 in an electrically isolated manner and downward-going edges are transferred by the photocoupler 312 also in an electrically isolated manner. Thus, it is possible to obtain the same signal as the input signal ① as the output signal of the SR flip-flop circuit 308.

Since the example of the first isolation circuit 300 described in FIG. 20 transfers only the differential signal component of the input signal ① in an electrically isolated manner using the photocouplers, it is possible to reduce current consumption because the time length during which the light-emitting device of a photocoupler turns on shortens dramatically, compared with methods that transfer the input signal ① as is in an electrically isolated manner.

The second isolation circuit 350 of FIG. 17 has the same configuration as the first isolation circuit 300 described above. The second isolation circuit 350 uses an SR flip-flop circuit with no inverting input for outputting the output signal D350.

Consequently, the sigma-delta analog-to-digital converter configured as shown in FIG. 17 has advantages resulting from the use of an isolation circuit that transfers differential signals across the point of isolation. If an isolation transformer is used as the isolation means, as shown in FIG. 18, it is possible to downsize the sigma-delta analog-to-digital converter and reduce its cost. If photocouplers are used as the isolation means, as shown in FIG. 20, it is possible to reduce the current consumption of the sigma-delta analog-to-digital converter.

In addition, the sigma-delta analog-to-digital converter of the present invention employs the means described below in order to stabilize its operation.

In the case of comparators and flip-flop circuits, it is generally impossible to determine whether their output becomes low or high the moment they are turned on. In other words, the output state of a comparator or flip-flop circuit is uncertain the moment it is turned on.

The sigma-delta analog-to-digital converter configured as shown in FIG. 17 operates in such a manner that the output D12 of the comparator 12 and the output D350 of the second isolation circuit 350 share the same polarity when they are in normal operation.

If the output D12 of the comparator 12 becomes high and the output D350 of the second isolation circuit 350 becomes low the moment the sigma-delta analog-to-digital converter is turned on, a signal, which is the sum of the inverted output D350 of the second isolation circuit 350 and the input signal Ain provided by the adder 15, is input to the integrator 11, causing the output A11 of an integrator 11 to saturate to the positive side. Consequently, the output D12 of the comparator 12 remains high and does not change, inhibiting the sigma-delta analog-to-digital converter from starting to operate.

Likewise, if the output D12 of the comparator 12 becomes low and the output D350 of the second isolation circuit 350 becomes high, the moment the sigma-delta analog-to-digital converter is turned on, a signal, which is the sum of the inverted output D350 of the second isolation circuit 350 and the input signal Ain provided by the adder 15, is input to the integrator 11, causing the output A11 of an integrator 11 to saturate to the negative side. Consequently, the output D12 of the comparator 12 remains low and does not change, also inhibiting the sigma-delta analog-to-digital converter from starting to operate.

If the sigma-delta analog-to-digital converter goes into this situation (hereinafter referred to as the state of abnormal stop) and its output remains unchanged, the converter can be restarted by forcibly inverting the output D300 of the first isolation circuit. The first and second startup circuits 400 and 450 in FIG. 16 are the circuits incorporated specifically for this purpose.

In FIG. 16, the output D13 of the flip-flop circuit is connected to the edge detector 451 of the second startup circuit 450, the output of which is connected to the reset terminal CLR of a counter circuit 452. The output of the counter circuit 452 is input to the inverting terminal RVS of the SR flip-flop circuit 308 in the first isolation circuit. The edge detector 451 is designed to detect a high-to-low or low-to-high transition in the output D13 of the flip-flop circuit 13 in order to produce a pulse signal.

The counter circuit 452 resets the count to zero if the signal input to the reset terminal CLR becomes high, starts to count up if the signal becomes low once again, and outputs a pulse signal when the count reaches the predetermined limit. In addition, when the power is turned on, the counter circuit 452 resets the count to zero and starts to count up.

The SR flip-flop circuit 308 having an inverting input inverts the output signal D300 when the signal input to the inverting terminal RVS becomes high.

Also in FIG. 16, the output D12 of the comparator 12 and the set signal Sin2 of the second isolation circuit 350 are input to the error detector ERR-S of the first startup circuit 400.

Likewise, the output D12 of the comparator 12 and the reset signal Rin2 of the second isolation circuit 350 are input to the error detector ERR-R of the first startup circuit 400.

The outputs ESo and ERo of the error detectors ERR-S and ERR-R are added to the output D12 of the comparator 12 by an adder 16. The output of the adder 16 is input to the first isolation circuit 300.

The error detectors ERR-S and ERR-R are designed to detect mismatches in logical state between the output D12 of the comparator 12 and the output D350 of the second isolation circuit 350.

The error detector ERR-R is designed to output a positive pulse signal ERo when the reset signal Rin2 is input from the second isolation circuit 350 with the output D12 of the comparator 12 set to the high state. The error detector ERR-S is designed to output a negative pulse signal ESo when the set signal Sin2 is input from the second isolation circuit 350 with the output D12 of the comparator 12 set to the low state.

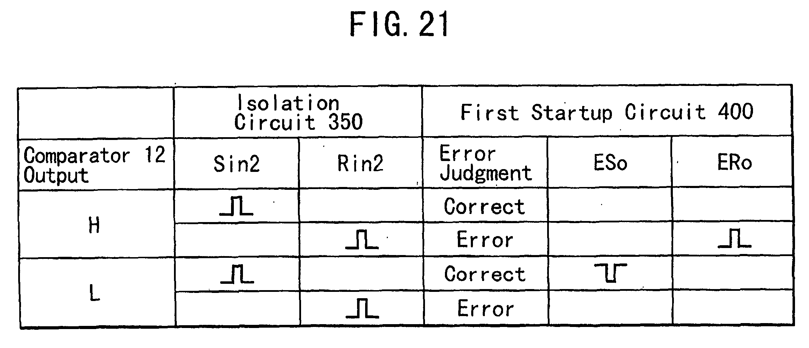

FIG. 21 shows this relationship.

The two output signals described above are added to the output D12 of the comparator 12 by the adder 16, and the resulting sum of the signals is input to the first isolation circuit 300.

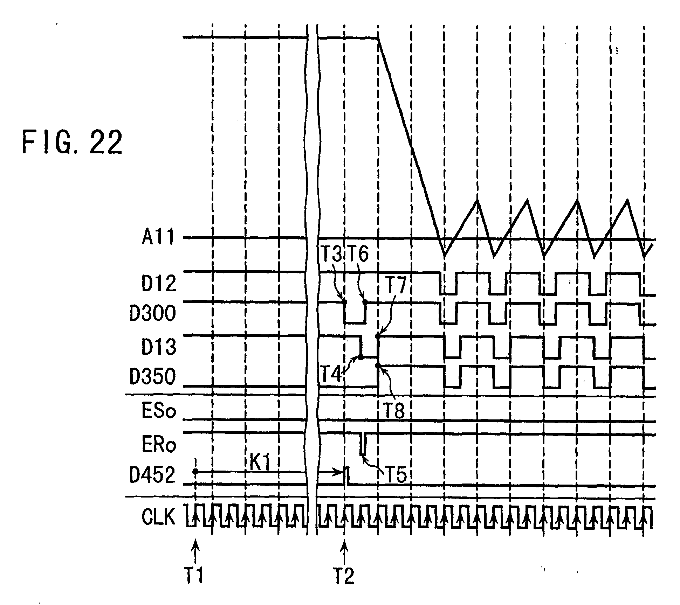

The first and second startup circuits configured as described above are explained by referring to the timing chart shown in FIG. 22. The timing chart in the figure shows the relationship among the input A11 and output D12 of the comparator 12, the output D300 of the first isolation circuit 300, the output D13 of the flip-flop circuit 13 (which is the input of the second isolation circuit 350), the output D350 of the second isolation circuit 350, the output ESo of the error detector ERR-S, the output ERo of the error detector ERR-R, the output D452 of the counter circuit 452, and the clock signal CLK.

FIG. 22 is a timing chart showing a case when the output D12 of the comparator 12 becomes high, the output D300 of the first isolation circuit 300 becomes high, and the output D350 of the second isolation circuit 350 becomes low the moment the sigma-delta analog-to-digital converter is turned on.

If in FIG. 22 a sigma-delta analog-to-digital converter of the type shown in FIG. 17 goes into the condition described above the moment it is turned on, it cannot start its operation.

The behavior of the first and second startup circuits 400 and 450 in order to resume normal operation is explained below.

At the time T1 when the power is turned on, the output D12 of the comparator 12 and the output D300 of the first isolation circuit 300 are high, and the output D350 of the second isolation circuit 350 is low. At the same time with the time T1, the timer circuit 452 starts to count up. The time interval K1 from when the counter circuit 452 starts to count up to when it expires is a period during which the sigma-delta analog-to-digital converter is at an abnormal stop.

When the timer circuit 452 expires, it outputs a pulse signal D452 (as indicated by the time T2).

The SR flip-flop circuit 308 having an inverting terminal inverts the output signal D300 by means of the pulse signal D452 input to the inverting terminal RVS (as indicated by the time T3). This causes the flip-flop circuit 13 to set its output D13 to the low state (as indicated by the time T4).

Consequently, the second isolation circuit 350 produces the reset signal Rin2. At this point, the error detector ERR-R compares the reset signal Rin2 with the output D12 of the comparator 12 and then judges the reset signal Rin2 to be faulty, thus producing the output ERo (as indicated by the time T5).

The output ERo is added to the output D12 of the comparator 12 by the adder 16, and the resulting signal is input to the first isolation circuit 300. Since the output ERo that is a negative pulse is added to the output D12 of the comparator 12 that is high, the signal input here to the first isolation circuit 300 is low for a period as long as the pulse width of the output ERo, and then goes back to the high state again.

The output D300 of the first isolation circuit 300 detects the upward-going edge of that input signal to latch its output signal D300 to the high state (as indicated by the time T6).

The flip-flop circuit 13 thereby sets its output signal D13 high (as indicated by the time T7), causing the second isolation circuit 350 to also set its output signal D350 high (as indicated by the time T8). Since this results in the agreement of the output D12 of the comparator 12 with the output D350 of the second isolation circuit 350, the sigma-delta analog-to-digital converter starts its normal operation.

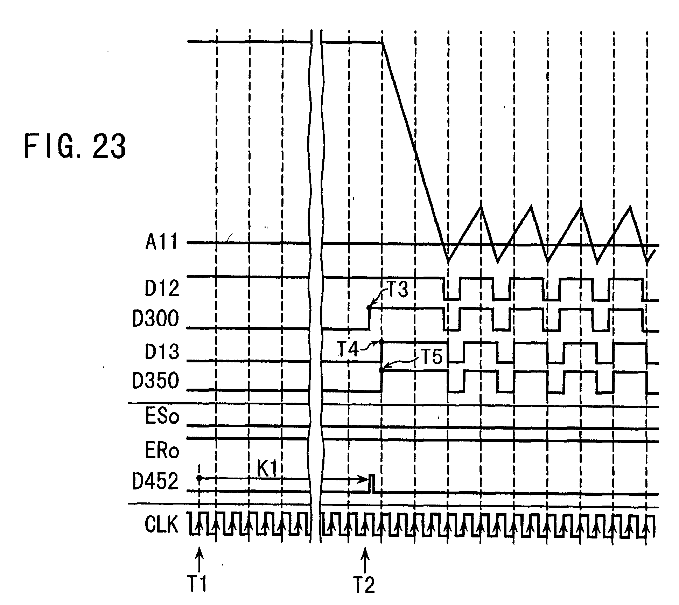

FIG. 23 is a timing chart showing a case when the output D12 of the comparator 12 becomes high, the output D300 of the first isolation circuit 300 becomes low, and the output D350 of the second isolation circuit 350 becomes low the moment the sigma-delta analog-to-digital converter is turned on.

The sigma-delta analog-to-digital converter cannot start its operation in this case either.

The behavior of the first and second startup circuits 400 and 450 in order to resume normal operation is explained below.

At the time T1 when the power is turned on, the output D12 of the comparator 12 is high, the output D300 of the first isolation circuit 300 is low, and the output D350 of the second isolation circuit 350 is low. At the same time with the time T1, the timer circuit 452 starts to count up. The time interval K1 from when the counter circuit 452 starts to count up to when it expires is a period during which the sigma-delta analog-to-digital converter is at an abnormal stop.

When the timer circuit 452 expires, it outputs a pulse signal D452 (as indicated by the time T2).

The SR flip-flop circuit 308 having an inverting terminal inverts the output signal D300 by means of the pulse signal D452 input to the inverting terminal RVS (as indicated by the time T3). This causes the flip-flop circuit 13 to set its output signal D13 high (as indicated by the time T4) and the second isolation circuit 350 to sets its output signal D350 also high (as indicated by the time T5). Since this results in the agreement of the output D12 of the comparator 12 with the output D350 of the second isolation circuit 350, the sigma-delta analog-to-digital converter resumes its normal operation.

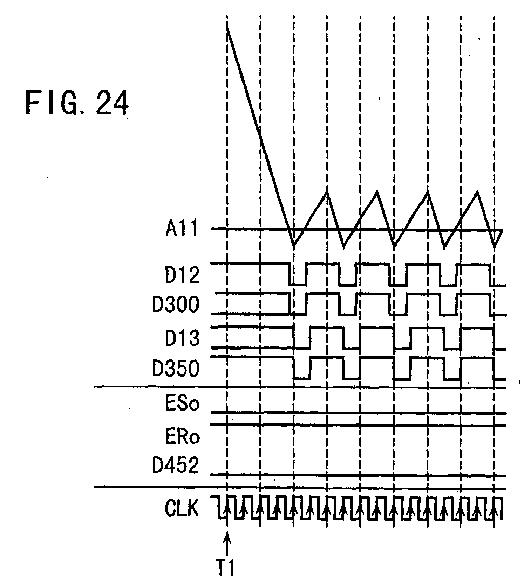

FIG. 24 is a timing chart showing a case when both the output D12 of the comparator 12 and the output D350 of the second isolation circuit 350 become high the moment the sigma-delta analog-to-digital converter is turned on.

Since this results in the agreement of the output D12 of the comparator 12 with the output D350 of the second isolation circuit 350, the sigma-delta analog-to-digital converter continues its normal operation. At this point, it does not matter whether the output D300 of the first isolation circuit 300 is low or high.

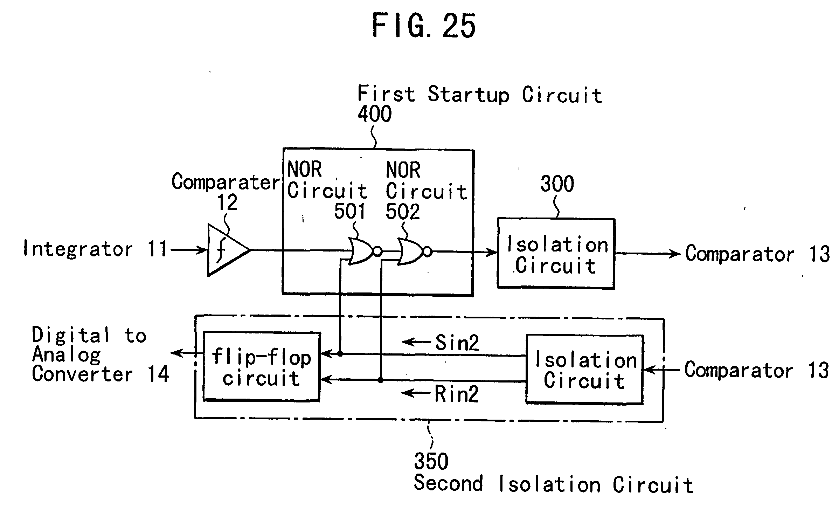

FIG. 25 shows an example of the startup circuit 400. In the figure, the first startup circuit 400 consists of 1) a first NOR circuit 501 wherein the output signal D12 of the comparator 12 is applied to one input of the first NOR circuit and the set signal Sin2 of the second isolation circuit 350 is applied to the other input of the first NOR circuit and 2) a second NOR circuit 502 wherein the output of the first NOR circuit is applied to one input of the second NOR circuit and the reset signal Rin2 of the second isolation circuit 350 is applied to the other input of the second NOR circuit.

The first startup circuit 400 shown in FIG. 16 is configured using the two error detectors ERR-S and ERR-R and the adder 16.

It is also possible to achieve the same effect as that of the first startup circuit 400 by using the circuit configured as described above.

In the explanation given above, only a specific preferred embodiment is mentioned for the purpose of describing the present invention and showing an example of carrying out the invention. The above-mentioned embodiment is therefore to be considered as illustrative and not restrictive.

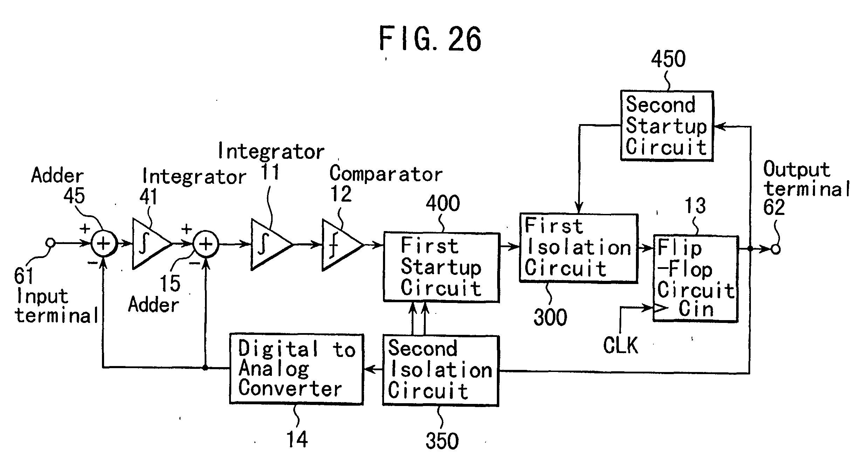

For example, the isolation means described in FIG. 16 is also effective for the double-integrator sigma-delta analog-to-digital converter shown in FIG. 26 where an adder 45 and an integrator 41 are added. It is possible to reduce the quantized noise of a sigma-delta analog-to-digital converter and improve its resolution, compared with the single-integrator type, by increasing the number of integrators as shown in FIG. 26.

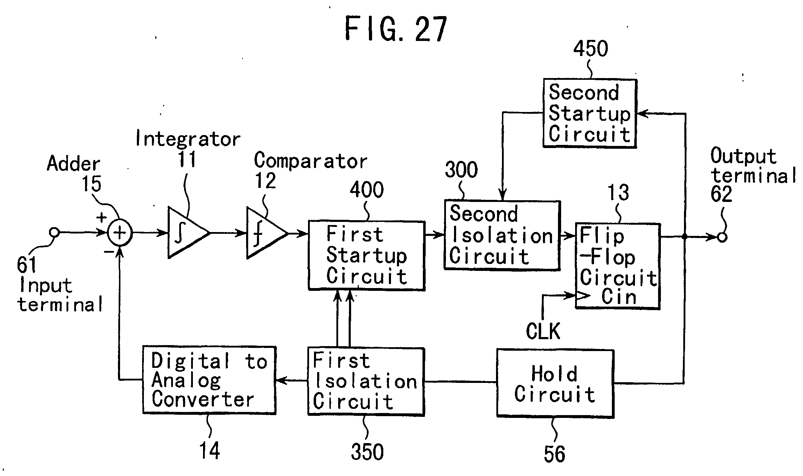

The isolation means described in FIG. 16 is also effective for a sigma-delta analog-to-digital converter where a hold circuit 56 is placed between the output terminal of the flip-flop circuit 13 and the digital-to-analog converter 14, as shown in FIG. 27. By adding the hold circuit 56 as shown in FIG. 27, the operating speed of an integrator 11 and a comparator 12 can be kept low, compared with the frequency of the clock signal CLK. This makes it possible to produce a sigma-delta analog-to-digital converter that requires less cost and operates at reduced currents.

**Claims**

1. A sigma-delta analog-to-digital converter comprising:

    an input terminal (61);
    an adder means (15);
    an integrator means (11);
    a comparator means (12) for comparing output of said integrator means (11) with a predetermined setpoint to provide result of comparison as a single bit digital value;
    a flip flop circuit (13) for holding output of said comparator means (12) in synchronization with a trigger signal applied to said flip flop circuit (13); and
    an output terminal (62), wherein an output signal from said flip flop circuit (13) is supplied to said output terminal; said sigma-delta analog-to-digital converter being **characterized by** further comprising:

    a digital-to-analog converter means (14);

    wherein an output signal from said flip flop circuit (13) is fed back to said adder means (15) through said digital-to-analog converter means (14) to output a pulse density signal corresponding to a given input signal; and
    further comprising said trigger control means (100) for controlling timing of a trigger signal to be applied to said flip flop circuit (13);
    wherein said trigger control means (100) comprises means configured so that the frequency at which said pulse density signal changes is restricted by limiting occurrence of said trigger signal for a predetermined period of time.

2. The converter of claim 1, wherein said trigger control means (100) comprises:

    means for driving a first controller (A) for detecting an upward going edge in an output signal of said comparator means (12) to generate a first trigger component signal; and
    means for driving a second controller (B) for detecting a downward going edge in an output signal of said comparator means (12) to generate a second trigger component signal; and
    means for providing a logical OR signal from said first and second trigger component signals.

3. The converter of claim 2, wherein said first controller (A) is configured so that when output of said comparator means (12) changes from a low state to a high state within a delay of a predetermined number of clock pulses, said first controller (A) generates said first trigger component signal after a delay of said predetermined number of clock pulses after the occurrence of a previous first trigger component signal; and so that when output of said comparator means (12) changes from said low state to said high state after delay of said predetermined number of clock pulses, said first controller (A) generates said first trigger component signal at a timing of a clock pulse immediately after said change.

4. The converter of claim 2, wherein said second controller (B) is configured so that when output of said comparator means (12) changes from a high state to a low state within a delay of a predetermined number of clock pulses, said second controller (B) generates said second trigger component signal after a delay of said predetermined number of clock pulses after the occurrence of a previous second trigger component signal; and so that when output of said comparator means (12) changes from said high state to said low state after delay of said predetermined number of clock pulses, said second controller (B) generates said second trigger component signal at a timing of a clock pulse immediately after said change.

5. The converter of claim 2, wherein said second controller (B) is configured to comprise an inverter means (102) connected to a circuit having the same configuration as said first controller (A).

6. The converter of claim 1, wherein said trigger control means (100) is configured to provide a double integrator sigma-delta analog-to-digital converter.


**Patentansprüche**

1. Sigma-Delta-Analog/Digital-Wandler, mit:

   einem Eingangsanschluss (61);
   einem Addierermittel (15);
   einem Integratormittel (11);
   einem Komparatormittel (12) zum Vergleichen der Ausgabe des Integratormittels (11) mit einem vorbestimmten Sollwert, um ein Ergebnis eines Vergleichs als einen Einzelbit-Digitalwert bereitzustellen;
   einer Flipflop-Schaltung (13) zum Halten der Ausgabe des Komparatormittels (12) synchron mit einem Triggersignal, das an die Flipflop-Schaltung (13) angelegt wird; und
   einem Ausgangsanschluss (62), wobei ein Ausgangssignal von der Flipflop-Schaltung (13) an den Ausganganschluss geliefert wird;

   wobei der Sigma-Delta-Analog/Digital-Wandler ferner **gekennzeichnet ist durch**:

   ein Digital/Analog-Wandlermittel (14),

   wobei ein Ausgangssignal von der Flipflop-Schaltung (13) an das Addierermittel (15) **durch** das Digital/Analog-Wandlermittel (14) zurückgeführt wird, um ein Impulsdichtesignal entsprechend einem gegebenen Eingangssignal auszugeben; und
   ferner mit dem Triggersteuermittel (100) zum Steuern des Timing eines an die Flipflop-Schaltung (13) anzulegenden Triggersignals;
   wobei das Triggersteuermittel (100) ein Mittel umfasst, das konfiguriert ist, um die Frequenz, bei der sich das Impulsdichtesignal ändert, **durch** Begrenzen des Auftretens des Triggersignals für eine vorbestimmte Zeitspanne beschränkt zu beschränken.

2. Wandler gemäß Anspruch 1, bei dem das Triggersteuermittel (100) umfasst:

   ein Mittel zum Treiben eines ersten Controllers (A) zum Erfassen einer nach oben gehenden Flanke in einem Ausgangssignal des Komparatormittels (12), um ein erstes Triggerkomponentensignal zu erzeugen; und
   ein Mittel zum Treiben eines zweiten Controllers (B) zum Erfassen einer nach unten gehenden Flanke in einem Ausgangssignal des Komparatormittels (12), um ein zweites Triggerkomponentensignal zu erzeugen; und
   ein Mittel zum Bereitstellen eines logischen ODER-Signals aus den ersten und zweiten Triggerkomponentensignalen.

3. Wandler gemäß Anspruch 2, bei dem der erste Controller (A) konfiguriert ist, so dass, wenn sich die Ausgabe des Komparatormittels (12) von einem Tiefpegelzustand in einen Hochpegelzustand innerhalb einer Verzögerung einer vorbestimmten Anzahl von Taktimpulsen ändert, der erste Controller (A) das erste Triggerkomponentensignal nach einer Verzögerung der vorbestimmten Anzahl von Taktimpulsen nach dem Auftreten eines vorherigen ersten Triggerkomponentensignals erzeugt; und so dass, wenn sich die Ausgabe des Komparatormittels (12) von dem Tiefpegelzustand in den Hochpegelzustand nach einer Verzögerung der vorbestimmten Anzahl von Taktimpulsen ändert, der erste Controller (A) das erste Triggerkomponentensignal mit einem Timing eines Taktimpulses direkt nach der Änderung erzeugt.

4. Wandler gemäß Anspruch 2, bei dem der zweite Controller (B) konfiguriert ist, so dass, wenn sich die Ausgabe des Komparatormittels (12) von einem Hochpegelzustand in einen Tiefpegelzustand innerhalb einer Verzögerung einer vorbestimmten Anzahl von Taktimpulsen ändert, der zweite Controller (B) das zweite Triggerkomponentensignal nach einer Verzögerung der vorbestimmten Anzahl von Taktimpulsen nach dem Auftreten eines vorherigen zweiten Triggerkomponentensignals erzeugt; und so dass, wenn sich die Ausgabe des Komparatormittels (12) von dem Hochpegelzustand in den Tiefpegelzustand nach einer Verzögerung der vorbestimmten Anzahl von Taktimpulsen ändert, der zweite Controller (B) das zweite Triggerkomponentensignal mit einem Timing eines Taktimpulses direkt nach der Änderung erzeugt.

5. Wandler gemäß Anspruch 2, bei dem der zweite Controller (B) konfiguriert ist, um ein Invertermittel (102) zu umfassen, das mit einer Schaltung verbunden ist, die die gleiche Konfiguration wie der erste Controller (A) aufweist.

6. Wandler gemäß Anspruch 1, bei dem das Triggersteuermittel (100) konfiguriert ist, um einen Doppelintegrator-Sigma-Delta-Analog/Digital-Wandler bereitzustellen.

**Revendications**

1. Convertisseur analogique/numérique sigma-delta, comprenant :

   une borne d'entrée (61) ;
   des moyens d'addition (15) ;
   des moyens d'intégration (11) ;
   des moyens de comparaison (12) pour comparer la sortie desdits moyens d'intégration (11) à un point de consigne prédéterminé afin de fournir un résultat de comparaison comme une valeur numérique à un seul bit ;
   un circuit bistable (13) pour contenir la sortie desdits moyens de comparaison (12) en synchronisme avec un signal de déclenchement appliqué audit circuit bistable (13) ; et
   une borne de sortie (62), dans lequel un signal de sortie provenant dudit circuit bistable (13) est fourni à ladite borne de sortie ;
   ledit convertisseur analogique/numérique sigma-delta étant **caractérisé en ce qu'**il comprend en outre :

   des moyens de conversion numérique/analogique (14) ;

   dans lequel un signal de sortie provenant dudit circuit bistable (13) est réinjecté dans lesdits moyens d'addition (15) à travers lesdits moyens de conversion numérique/ analogique (14) pour délivrer un signal de densité d'impulsions correspondant à un signal d'entrée donné ; et
   **en ce qu'**il comprend en outre lesdits moyens de commande de déclenchement (100) pour commander la temporisation d'un signal de déclenchement à appliquer audit circuit bistable (13) ;
   dans lequel lesdits moyens de commande de déclenchement (100) comprennent des moyens configurés de telle sorte que la fréquence à laquelle ledit signal de densité d'impulsions change est restreint en limitant l'occurrence dudit signal de déclenchement pendant une période de temps prédéterminée.

2. Convertisseur selon la revendication 1, dans lequel lesdits moyens de commande de déclenchement (100) comprennent :

   des moyens pour piloter un premier contrôleur (A) pour détecter un bord montant dans un signal de sortie desdits moyens de comparaison (12) afin de générer un premier signal de composante de déclenchement ; et
   des moyens pour piloter un deuxième contrôleur (B) pour détecter un bord descendant dans un signal de sortie desdits moyens de comparaison (12) pour générer un deuxième signal de composante de déclenchement ; et
   des moyens pour fournir un signal OU logique à partir desdits premier et deuxième signaux de composante de déclenchement.

3. Convertisseur selon la revendication 2, dans lequel ledit premier contrôleur (A) est configuré de telle sorte que lorsque la sortie desdits moyens de comparaison (12) passe d'un état bas à un état haut dans un délai d'un nombre prédéterminé d'impulsions d'horloge, ledit premier contrôleur (A) génère ledit premier signal de composante de déclenchement après un délai dudit nombre prédéterminé d'impulsions d'horloge après l'occurrence d'un premier signal de composante de déclenchement précédent ; et de telle sorte que lorsque la sortie desdits moyens de comparaison (12) passe dudit état bas audit état haut après le délai dudit nombre prédéterminé d'impulsions d'horloge, ledit premier contrôleur (A) génère ledit premier signal de composante de déclenchement à une temporisation d'une impulsion d'horloge immédiatement après ledit changement.

4. Convertisseur selon la revendication 2, dans lequel ledit deuxième contrôleur (B) est configuré de telle sorte que lorsque la sortie desdits moyens de comparaison (12) passe d'un état haut à un état bas dans un délai d'un nombre prédéterminé d'impulsions d'horloge, ledit deuxième contrôleur (B) génère ledit deuxième signal de composante de déclenchement après un délai dudit nombre prédéterminé d'impulsions d'horloge après l'occurrence d'un deuxième signal de composante de déclenchement précédent ; et de telle sorte que lorsque la sortie desdits moyens de comparaison (12) passe dudit état haut audit état bas après le délai dudit nombre prédéterminé d'impulsions d'horloge, ledit deuxième contrôleur (B) génère ledit deuxième signal de composante de déclenchement à une temporisation d'une impulsion d'horloge immédiatement après ledit changement.

5. Convertisseur selon la revendication 2, dans lequel ledit deuxième contrôleur (B) est configuré pour comprendre des moyens inverseurs (102) connectés à un circuit présentant la même configuration que ledit premier contrôleur (A).

6. Convertisseur selon la revendication 1, dans lequel lesdits moyens de commande de déclenchement (100) sont configurés pour prévoir un convertisseur analogique/numérique sigma-delta à deux intégrateurs.

FIG. 1

# FIG. 2

Ain ○— 15 Adder · 11 Integrator · 12 Comparator — flip-flop circuit — Clock CLK — 62 Output terminal ○D13

A11 · D12 · D13 · 13

61 Input terminal

Digital to Analog Converter — A14 — 14

EP 0 989 678 B1

# FIG. 3

# FIG. 4

15 Adder   11 Integrator   12 Comparator

Ain

61
Input
terminal

flip-flop
circuit

13

Isolation
Circuit

25

Clock CKL

62 Output
terminal

D13

Digital
to Analog
Converter

14

EP 0 989 678 B1

FIG. 5

Clock CLK

62 Output terminal

D13

flip-flop circuit 13

D13

12 Comparator

D12

Isolation Circuit 35

11 Integrator

A11

Digital to Analog Converter 14

15 Adder

Input terminal

Ain 61 Input terminal

# FIG. 6

# FIG. 7

EP 0 989 678 B1

# FIG. 8

# FIG. 9

(a)

S1

TRG

CLK

④ ① ②

n Clock

(b)

S1

TRG

CLK

③

n Clock

EP 0 989 678 B1

# FIG. 10

# FIG. 11

| | | |
|---|---|---|
| Sampling frequency | fs | $\frac{n}{2} \cdot fs$ |
| Maximum frequency of FF output | $\frac{fs}{2}$ | $\frac{fs}{2}$ |
| SN | 1 | $\frac{n}{2}$ |

FIG. 12

# FIG. 13

| | | |
|---|---|---|
| Sampling frequency | $fs$ | $\dfrac{n}{2} \cdot fs$ |
| Maximum frequency of FF output | $\dfrac{fs}{2}$ | $\dfrac{fs}{2}$ |
| SN | 1 | $k^2 \left(\dfrac{n}{2}\right)^3$ |

EP 0 989 678 B1

# FIG. 14

Controler A

AND Circuit
203

S1

TRIGGER

a

TIMER
RST

φ1

CLK

202

201

φ0

EP 0 989 678 B1

# F I G. 15

(a)

(b)

# FIG. 16

# FIG. 17

EP 0 989 678 B1

FIG. 18

# FIG. 19

EP 0 989 678 B1

# FIG. 20

Input terminal 301

Condenser 302a

Resistor 304 VCC

Photocoupler 311

Inverter 309

flip-flop circuit 308

Inverter 313

Resistor 306 VCC

Inverter 310

Condenser 302b

Photocoupler 312

S R

D300

# FIG. 21

| Comparator 12 Output | Isolation Circuit 350 | | First Startup Circuit 400 | | |
|---|---|---|---|---|---|
| | Sin2 | Rin2 | Error Judgment | ESo | ERo |
| H | ⊓ | | Correct | | |
| | | ⊓ | Error | | ⊓ |
| L | ⊓ | | Correct | ⊔ | |
| | | ⊓ | Error | | |

EP 0 989 678 B1

FIG. 22

FIG. 23

A11
D12
D300
T3
D13
T4
T5
D350
ESo
ERo
D452
K1
CLK

T1
T2

EP 0 989 678 B1

FIG. 24

EP 0 989 678 B1

# FIG. 25

First Startup Circuit
400

Comparater
12

NOR Circuit 501   NOR Circuit 502

300

Integrator 11 →

Isolation Circuit → Comparator 13

Digital to Analog Converter 14 ←

flip-flop circuit

← Sin2

Isolation Circuit ← Comparator 13

← Rin2

350
Second Isolation Circuit

EP 0 989 678 B1

# FIG. 26

EP 0 989 678 B1

# FIG. 27

Integrator 11

Comparator 12

Adder 15

Input terminal 61

First Startup Circuit 400

First Isolation Circuit 350

Digital to Analog Converter 14

Second Isolation Circuit 300

Second Startup Circuit 450

Flip-Flop Circuit Cin 13

CLK

Hold Circuit 56

Output terminal 62